(19) Europäisches Patentamt
European Patent Office
Office européen des brevets

(11) Publication number: **0 400 749 A1**

(12) **EUROPEAN PATENT APPLICATION**

(21) Application number: **90201362.2**

(51) Int. Cl.[5]: **C08G 61/00, C08G 73/12**

(22) Date of filing: **29.05.90**

(30) Priority: **30.05.89 US 359001**
**30.05.89 US 358742**

(43) Date of publication of application:
**05.12.90 Bulletin 90/49**

(84) Designated Contracting States:
**BE DE ES FR GB IT NL**

(71) Applicant: **SHELL INTERNATIONALE RESEARCH MAATSCHAPPIJ B.V.**
**Carel van Bylandtlaan 30**
**NL-2596 HR Den Haag(NL)**

(72) Inventor: **Corley, Larry Steven**
**6807 San Pablo Drive**
**Houston, Texas 77083(US)**

(74) Representative: **Aalbers, Onno et al**
**P.O. Box 302**
**NL-2501 CH The Hague(NL)**

(54) **Bisbenzocyclobutene/bisimide compositions.**

(57) Heat-curable compositions comprising:

a) at least one difunctional bisimide of an unsaturated dicarboxylic acid,
b) 0.6-2.5 moles of a bisbenzocyclobutene per mole of difunctional bisimide, and
c) optionally a free radical polymerization inhibitor for the bisimide.

EP 0 400 749 A1

Xerox Copy Centre

## BISBENZOCYCLABUTENE/BISIMIDE COMPOSITIONS

This invention relates to thermosettable resin compositions. More in particular the invention relates to thermosettable compositions comprising a bisimide and a bisbenzocyclobutene, and to the copolymers derived therefrom.

Advanced composites are high-performance materials made up of a fibre-reinforced thermoplastic or thermosettable (hereinafter referred to as heat-curable) material. Heat-curable materials useful in advanced composite applications must meet a set of demanding property requirements. For example, such heat-cured materials optimally should have good high-temperature properties such as high (above 200 °C) glass transition temperature and low (less than 3%) water absorption at elevated temperature, as well as high mechanical strength, as reflected in measurements of Mode 1 fracture toughness above 2 $MPa.m^{1/2}$ and good compression after impact. For ease of processing in preparing prepregs for composite parts, the uncured material will ideally have a low (below 120 °C) melting temperature.

Examples of heat-curable materials useful in advanced composites include bisbenzocyclobutenes and bismaleimides.

Standard homopolymers of bisbenzocyclobutenes (as described in the examples of U.S. 4,540,763) are brittle unless very high molecular weight bisbenzocyclobutenes are used. If very high molecular weight bisbenzocyclobutenes are used, however, the materials are difficult to process into fibre-reinforced composites because of their high viscosity. Bismaleimides have this same disadvantage of brittleness and further tend to have high melting points and must be used with solvents in order to be readily processable. In addition, cured bismaleimides, hereinafter referred to as polymers, tend to have high (in the 5-7% range) water absorption. Copolymers of bisbenzocyclobutenes and bismaleimides as illustrated in the Example of U.S. 4,730,030 have good mechanical strength and heat resistance but, like the cured homopolymers, they lack the necessary toughness for high-performance applications. A further deficiency experienced with bisbenzocyclobutene/bismaleimide uncured mixtures is that they tend to exhibit viscosity instability in the molten state.

It is thus an object of the present invention to provide low-melting bisbenzocyclobutene/bisimide compositions which cure to a high-Tg, tough copolymer, having low water absorption, and/or having improved viscosity stability.

As a result of extensive research and experimentation novel heat-curable compositions could be developed which do not suffer from one or more of the disadvantages mentioned hereinbefore, and which compositions are based on a combination of at least a bisimide, a specified amount of a bisbenzocyclobutene and optionally a polymerization inhibitor.

Accordingly the invention provides heat-curable compositions comprising:

a) at least one difunctional bisimide of an unsaturated dicarboxylic acid,

b) 0.6-2.5 moles of a bisbenzocyclobutene per mole of bisimide, and

c) optionally a free radical polymerization inhibitor for the bisimide.

The bisimide present in the compositions of the present invention are preferably N′N′-bisimides of unsaturated dicarboxylic acids which can be represented by the formula

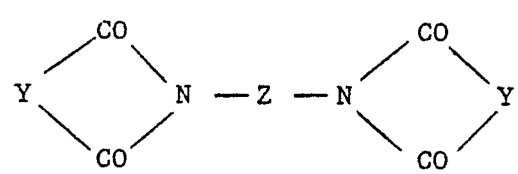

in which Y is a substituted or unsubstituted divalent group containing at least 2 carbon atoms, preferably 2 to 6 carbon atoms, and a carbon-carbon double bond, and Z is a divalent group containing at least 1 and generally from 1 to 40 carbon atoms. can be aliphatic, cycloaliphatic, aromatic or heterocyclic. A preferred class of bisimides comprises bismaleimides derived from aromatic diamines and can be represented by the formula

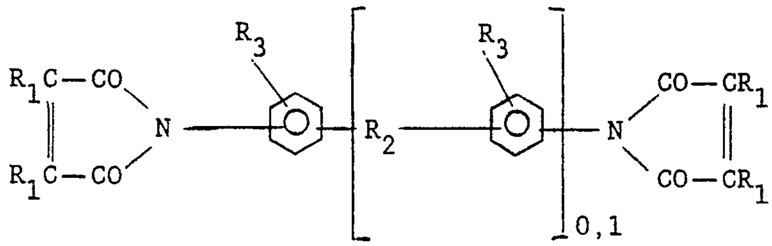

wherein each $R_1$ independently represents H, a $C_{1-2}$ alkyl or halide; $R_2$ represents a divalent hydrocarbon radical containing from 1 to carbon atoms, or -O-, $-SO_2$ -, -COO-, -CONH-, -CO- and -S-; and each $R_3$ independently represents H, a $C_{1-3}$ alkyl or halide.

Examples of such bisimides include

1,2-bismaleimidoethane
1,6-bismaleimidohexane
1,3 -bismaleimidobenzene
1,4-bismaleimidobenzene
2,4-bismaleimidotoluene
4,4′-bismaleimidodiphenylmethane
4,4′-bismaleimidodiphenylether
3,3′-bismaleimidodiphenylsulfone
4,4′-bismaleimidodiphenylsulfone
4,4′-bismaleimidodicyclohexylmethane
3,5-bis(4-maleimidophenyl)pyridine
2,6-bismaleimidopyridine
1,3-bis (maleimidomethyl)cyclohexane
1,3-bis (maleimidomethyl)benzene
1,1-bis(4-maleimidophenyl)cyclohexane
1,3 -bis (dichloromaleimido)benzene
4,4′-biscitraconimidodiphenylmethane
2,2-bis(4-maleimidophenyl)propane
1-phenyl-1, 1-bis(4-maleimidophenyl)ethane
α,α-bis(4-maleimidophenyl)toluene
3,5-bismaleimido-1,2,4-triazole

and various N,N′-bismaleimides disclosed in U.S. 3,562,223, 4,211,860 and 4,211,861. Bismaleimides can be prepared by methods known in the art, as described in U.S. 3,018,290, for example.

Bisimides can contain an imide oligomer such as for example an oligomer of the formula

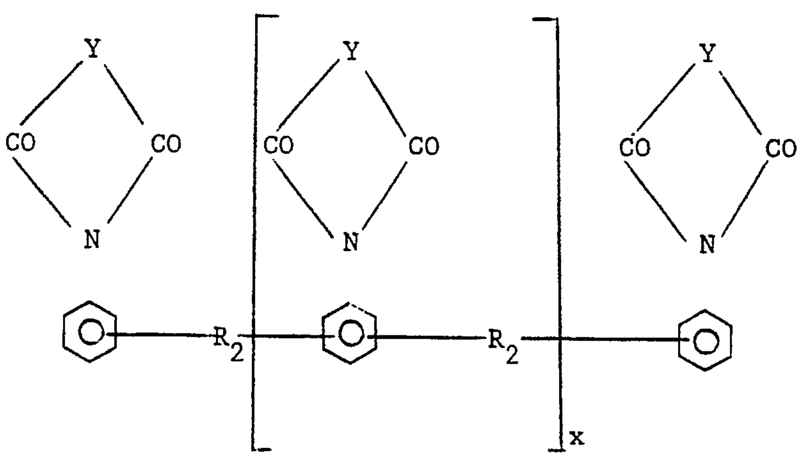

in which x is a number within the range of from 0 to 0.5. Such oligomers may be present as an impurity in difunctional bisimides.

A preferred bisimide is 4,4′-bismaleimidodiphenylmethane. The bisimide can contain various additives

and modifiers as processing aids. The bisimide component can be a reaction product or prepolymer of a bisimide and an effective chain-extending agent such as an amine group-containing compound. Suitable amine group-containing compounds include diamines and polyamines represented by the general formula $(H_2N)_nQ$ or $(RNH)_nQ$ and aminophenols represented by the general formula $(NH_2)_nQ(OH)_n$ or $(RNH)_nQ(OH)_n$, in which Q is a divalent aromatic or alicyclic group and n is a number such that the average number of aminohydrogens per molecule in the amine mixture falls between about 1.95 and 2.5. Examples include bis-(4-(N-methylamino)phenyl)methane, N,N′-dimethyl-1,3-diaminobenzene and the like. Such reaction products can be prepared by methods known in the art. Further suitable bisimides are, for example, hydrazide-modified bismaleimides as described in U.S. 4,211,860 and 4,211,861.

It will be appreciated that as bisimide component also mixtures of bisimides may be used in order to prevent possible crystallisation of a specific bisamide from its molten mixture with bisbenzocyclobutene component.

Preferred bisbenzocyclobutene components of the heat-curable compositions of the present invention are those of general formula I, II or III

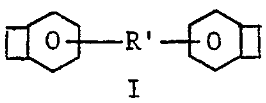
I

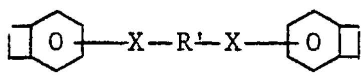
II

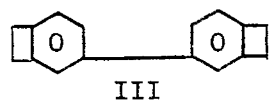
III

in which R′ is selected from unsubstituted and non-electrophilic substituted phenylene, naphthylene, and

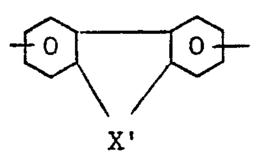

, where X is selected from oxygen, sulphur, nitrogen $-CH_2$ - and $-C(CH_3)_2-$, and X′ is selected from O, S, N and $-CH_2-$. Typical examples for R′ include 1,2-, 1,3- and 1,4-phenylene, 2,7-naphthylene and dibenzofurandiyl. In a preferred bisbenzocyclobutene of formula 1, R′ is 1,3-phenylene.

The preparation of bisbenzocyclobutenes is known generally in the art, for example from U.S. 4,540,763 and U.S. 4,711,964.

Preferably the bisbenzocyclobutene and bisimide components are employed in a molar ratio of from 0.7:1 to 1.3:1 and more preferably in a ratio of 0.9:1 to 1.1:1.

When the heat-curable compositions of the present invention include a free radical polymerization inhibitor, such an inhibitor will be present in an amount which is effective to inhibit the free radical polymerization of the bisimide. Generally, the free radical inhibitor will be present in the composition in an amount within the range of from 0.0002 to 0.02 moles per mole of the bisimide, and preferably from 0.001 to 0.01 moles.

The bisimide and bisbenzocyclobutene components may be combined in any manner desired, such as melt, solution or powder blending. The preferred technique involves melting a mixture of the solid compounds containing the desired quantities of each component at a temperature above the respective melting points but below the polymerization temperature of either component, and stirring the melt until a homogeneous mixture is achieved. The melt may also be held at temperatures above 200 °C for desired periods of time in a process of prepolymerization to increase the crystallization resistance of the melt and/or to increase its viscosity to desired levels. The mixture can then be poured directly into a mould for polymerization, or it can be cooled for later polymerization.

The free radical inhibitor can be added to the mixture in any manner effective for intimate blending therewith, such as melt-blending a mixture of the bisimide and bisbenzocyclobutene components and the free radical inhibitor. The most pronounced effects of the radical inhibitor on copolymer toughness is in the near-stoichiometric ranges.

The preferred free radical inhibitor, because of the demonstrated toughness of the resulting copolymers, is phenothiazine.

Polymerization is effected by heating the mixture to a temperature effective to initiate opening of the benzocyclobutene rings to form a transient diene which rapidly reacts with available imide groups. This temperature is generally at least 180 °C, preferably in the range of from 210 to 350 °C, and maintained for a time of 2 hours or more (with the required cure time dependent on the temperature-staging program used).

In order to achieve the superior properties exhibited by the copolymers of the invention, a mixture of the components is heated at a temperature near (within 15° C below) or above the ultimate glass transition temperature ($Tg_u$) of the fully-cured copolymer for a time sufficient to produce essentially complete reaction of the components. "Essentially complete" reaction of the components has been reached when no further reaction exotherm is observed by differential scanning colorimetry (DSC) upon heating the copolymer. The time of the heat treatment, or "post-cure," will vary depending upon the bisimide and bisbenzocyclobutene components, the degree of pressure applied and any pre-curing of the component mixture at temperatures lower than ($Tg_u$ - 15° C). Preferably, this post-cure is at or above the $Tg_u$, most preferably at least 20° C above $Tg_u$, but will always be lower than the temperature at which degradation of the copolymer will occur.

The cured bisimide/bisbenzocyclobutene copolymers are characterized by glass transition temperatures (dynamic mechanical) generally above 200° C, Mode I toughness (ASTM E 399-83 using 1x1x1/8″ samples) greater than 2.0 MPa.m$^{1/2}$, preferably greater than 2.5, most preferably greater than 3.0, and water absorption (93° C) less than 3%, and preferably less than 2.0%. Methyl ethyl ketone absorption (room temperature) is less than 3% in the preferred species.

The copolymers are useful as matrices for composites in aerospace and electronics applications, including large structural parts and circuit boards. Based on their long shelf life and relatively low melting point, some of the uncured mixtures are useful for making tacky prepregs which can then be moulded into composites. They are also suitable for low-solvent or solventless liquid resin processing methods such as filament winding, resin transfer moulding and pultrusion if the mixtures are heated to provide sufficiently low viscosity for fibre impregnation.

For preparation of reinforced laminate materials, a fibrous substrate of glass, carbon, quartz, poly(p-phenyleneterephthalamide), polyester, polytetrafluoroethylene, poly(p-phenylenebenzobisthiazole), boron, paper or like material, in chopped, mat or woven form, is impregnated with a bisimide/bisbenzocyclobutene composition in molten or solution form. A prepreg is formed by heating the impregnated substrate in an oven at a temperature sufficient to remove the solvent and to partially cure without gelation, or "B-stage," the system, which temperature is in the range of from generally 180° C to 230° C, preferably from 200 to 220° C, for a time of up to 2 hours, preferably for a time in the range of from 10 to 40 minutes. A laminate is fabricated by subjecting a set of layered prepregs to conditions effective to cure the system and to integrate the prepregs into a laminated structure. The laminate can optionally include one or more layers of a conductive material such as copper.

Laminating generally involves subjecting the prepregs to a temperature above 200° C, preferably from 210 to 350° C, for a time of at least 1 hour, at a pressure within the range of 50 to 500 psi.

For some laminating applications, it has been found advantageous to heat treat, or upstage, the bisimide/bisbenzocyclobutene (B1/BCB) mixture prior to application to a laminating substrate, particularly if the mixture will be stored prior to use. Suitable heat treatment involves subjecting the (BI/BCB) mixture to an elevated temperature for a time sufficient to cause sufficient reaction and viscosity increase to inhibit crystallization of either or both of the components from the mixture upon storage, but not sufficient to gel the composition. Such heat treatment conditions generally include a temperature of at least 200° C, preferably 210 to 230° C, for a time of at least 10 minutes, preferably 12 to 90 minutes. The resulting mixture will be less tacky and less susceptible to crystallization of the components with storage.

The invention will be further illustrated by the following examples for which the following information is provided:

a) Preparation of 4,4′-(1,3-phenylenedioxy)bisbenzocyclobutene

Into a 5-litre, 4-neck round bottom glass flask were weighed 205.2 grams (3.80 moles) of sodium methoxide, 220.2 grams (2.00 moles) of resorcinol, and 2500 grams of pyridine. The flask was then fitted with a paddle stirrer, stirrer rod and bearing, a thermometer, and a Vigreux column, distilling head 'and receiving flask for distillation. The apparatus was purged with nitrogen using a Firestone valve (U.S. Pat. 4,131,129) and distillation was started with stirring in order to remove methanol and form the disodium salt of resorcinol. Slow distillation was continued until the top of the column had come to constant temperature at the boiling point of pyridine. When methanol removal was complete, the Vigreux column was removed and replaced with a reflux condenser.

To the flask were then added 732.2 grams (4.00 moles) of dry 4-bromobenzocyclobutene. About 425 mL of a solution of CuCl in dry pyridine, containing about 3.6% CuCl, was placed in an addition funnel which was placed atop the flask. The system was purged again with nitrogen using the Firestone valve, 175 mL of the CuCl solution was allowed to flow into the flask, and reflux was started with gentle stirring. Reflux

was continued for approximately 66 hours with periodic portionwise addition of the remaining CuCl solution. Approximately 75 mL of the remaining CuCl solution was added after 18 hours, 75 mL after 27 hours, 50 mL after 42 hours, and the remaining 50 mL after 51 hours.

The pyridine was then removed by vacuum distillation followed by removal of unreacted 4-bromobenzocyclobutene by steam distillation. The pot residue was then taken up in approximately 750 grams of cyclohexane and filtered. The cyclohexane solution was successively extracted with 300 grams each of 5%, 10%, 20%, and 40% aqueous NaOH solutions and then with 300 grams of 70% aqueous $H_2SO_4$ followed by 300 grams of water. The cyclohexane was then removed under reduced pressure on a rotary evaporator to yield 387.9 grams (1.234 moles, 64.9%) of crude 4,4′-(1,3-phenylenedioxy)bisbenzocyclobutene which crystallized on standing. Recrystallization from 550 grams of hexane yielded 272.8 grams of crystals melting at 60-61.5 °C. and with a purity of about 96% by liquid chromatography. Additional crops of crystals could be obtained by concentrating and cooling the mother liquor. Other crystallized batches of material had melting points as high as 65 °C and liquid chromatographic peak area percentages of over 98%.

b) Preparation of 4,4′-(2,7-naphthylenedioxy)bisbenzocyclobutene

Into a 2-litre, 4-neck round bottom glass flask were weighed 82.1 grams (1.52 moles) of sodium methoxide, 128.1 grams (0.80 moles) of 2,7-naphthalenediol, and 1200 grams of pyridine. The flask was then fitted with a paddle stirrer, stirrer rod and bearing, a thermometer, and a Vigreux column, distilling head and receiving flask for distillation. The apparatus was purged with nitrogen using a Firestone valve (U.S. Pat. 4,131,129) and distillation was started with stirring in order to remove methanol and form the disodium salt of 2,7-naphthalenediol. Slow distillation was continued until the top of the column had come to constant temperature at the boiling point of pyridine. When methanol removal was complete, the Vigreux column was removed and replaced with a reflux condenser.

To the flask were then added 293 grams (1.60 moles) of dry 4-bromobenzocyclobutene. About 250 mL of a solution of CuCl in dry pyridine, containing about 3.6% CuCl, was placed in an addition funnel which was placed atop the flask. The system was purged again with nitrogen using the Firestone valve, 75 mL of the CuCl solution was allowed to flow into the flask, and reflux was started with gentle stirring. Reflux was continued for approximately 115 hours with periodic portionwise addition of the remaining CuCl solution. Approximately 50 mL of the remaining CuCl solution was added after 28 hours, 50 mL after 56 hours, 50 mL after 80 hours, and the remaining 25 mL after 99.5 hours.

The pyridine and unreacted 4-bromobenzocyclobutene were then removed by steam distillation (in the presence of excess base, and with an air sparge to promote oxidation of unreacted phenolic materials). The pot residue was then taken up in approximately 1.5 litres of cyclohexane and filtered. The cyclohexane solution was successively extracted with 240 grams of 40% aqueous NaOH, 240 grams of 70% aqueous $H_2SO_4$, and two 200-gram portions of water. The cyclohexane was then removed under reduced pressure on a rotary evaporator to yield 163.3 grams (0.45 moles, 59.0%) of crude 4,4′-(2,7-naphthylenedioxy)-bisbenzocyclobutene which crystallized on standing. Recrystallization from about 500 g of ethanol (later substituted by isopropyl alcohol) yielded 7 successive crops of crystals totalling 105.3 grams and with melting points between 83 °C and 88.5 °C. The major impurities remained in an "oil" phase which never dissolved in the isopropyl alcohol.

c) Preparation of 4,4′-(1,3-phenylene)bisbenzocyclobutene

All glassware used in this experiment was dried overnight in an oven at 120 °C before use. Into a 1-litre, 4-neck round bottom glass flask were weighed 12.16 grams (0.5 mole) of magnesium turnings. The flask was then fitted with a thermometer, a condenser, a magnetic stirrer, and two addition funnels. To one addition funnel was added 91.5 grams (0.5 mole) of 4-bromobenzocyclobutene. To the other was added 250 mL of dry tetrahydrofuran. The system was purged with nitrogen. Small portions of the 4-bromobenzocyclobutene and tetrahydrofuran were dropped onto the magnesium and stirred until the Grignard reaction had started (which occurred in approximately 5 minutes). The reaction mixture was then cooled with an ice-water bath and the rest of the 4-bromobenzocyclobutene and tetrahydrofuran were added over approximately 30 minutes, with continued stirring and ice-bath cooling. During this period, the temperature of the reaction mixture was 45-55 °C. The reaction mixture was then allowed to cool (without application of external heat or cooling) to room temperature over the next approximately 2-1/2 hours as the magnesium was consumed.

Then, under a stream of nitrogen, 0.46 grams of powdered 1,2-bis(diphenylphosphino)ethanenickel(II)-chloride were added to the Grignard reagent in the pot and 33 grams (0.225 mole) of 1,3-dichlorobenzene were added to one of the separatory funnels. The 1,3-dichlorobenzene was then added dropwise, with stirring, from the separatory funnel to the mixture of Grignard reagent and nickel catalyst. When addition was complete, the solution was heated to slow reflux and the reflux was continued overnight, with stirring.

The following morning, water was added to the mixture to decompose unreacted Grignard reagent. The mixture was then steam-distilled for approximately 6 hours to remove volatiles and then cooled to near room temperature. The organic portion was then taken up in approximately 200 mL of dichloromethane. The aqueous phase was then made slightly acid, the phases were separated, and the dichloromethane solution was dried over calcium chloride pellets and then evaporated in a rotary evaporator. The crude yield was 40 grams. Recrystallization from 200 mL of ethanol yielded three initial crops of crystals totalling 14 grams, which were then used in casting preparation in Example 5 below. The melting range of the crystals from the first crop was 94.5-96 °C.

EXAMPLE I

Preparation of Copolymers

Into a perfluoropolymer beaker were weighed 50.20 grams of 4,4′-bismaleimidodiphenylmethane, 8.45 grams of 2,4-bismaleimidotoluene, 8.03 grams of 1,3-bismaleimidobenzene, and 0.2019 grams of phenothiazine (added as an inhibitor of radical polymerization of the bismaleimides on heating). The mixture was heated in an oven to 160-180 °C, stirred until homogeneous, and allowed to cool to room temperature, solidifying to an amorphous mass, which mass was then broken up into small pieces. (The bismaleimide mixture was used instead of a single bismaleimide resin to prevent the bismaleimide from crystallizing from its molten mixture with the bisbenzocyclobutene component.)

A number of blends of the above bismaleimide mixture (or similar mixtures prepared by the same procedure, or mixtures which were similar in composition but without phenothiazine) with 4,4′-(1,3-phenylenedioxy)bisbenzocyclobutene were prepared as follows. The above bismaleimide mixture and the bisbenzocyclobutene resin were weighed into 30-mL or 50-mL glass beakers in the proportions shown in Table 1 below (mixture sizes were about 10 to 12 grams). The beakers were then heated in an air oven until the contents had melted. The contents were stirred until homogeneous and in some cases were upstaged by placing the beakers in a 220 °C oil bath for 20 minutes. The mixtures were then degassed under vacuum at 180-190 °C. The mixtures were then poured into moulds formed from two sheets of glass separated by a 1/16″ (1.6 mm) polytetrafluoroethylene spacer and held together by clamps. The moulds were then placed into an oven and cured by a number of cure cycles as shown in Table 1 below. The first group of cure cycles involved cure for approximately 2 1/2 hours at 210 °C followed by 15 minutes at each of the following temperatures: 220 °C, 230 °C, 240 °C, and 250 °C. The second major type of cure included 3 hours at 210 °C followed by 15 minutes at each of the following temperatures: 230 °C, 250 °C, and 270 °C, and then a 1 hour postcure at 290 °C. The moulds were then allowed to cool to below 150 °C and the cured resin castings were removed from the moulds. Physical properties of the castings were then determined as shown in Table 1 below. The dependence of dynamic mechanical Tg and compact tension fracture toughness on composition and cure cycle is shown in Figures 1 and 2.

None of the samples increased in weight after immersion in methyl ethyl ketone at room temperature for as long as 2 weeks.

One can see from Table 1 and Figure 2 the high toughness obtained for the copolymers. For all cure cycles and both with and without phenothiazine, toughness peaks fairly sharply in the region of equimolar content of BCB and maleimide groups (0.5 mole fraction BCB resin), and Tg reaches a minimum in this range. Outside this range, for mixtures with excess BCB resin and a 15-minute 250 °C postcure, toughness drops off significantly well before there is a substantial increase in Tg. For mixtures with excess BMI and a cure cycle with a 15-minute 250 °C postcure, the mixtures abruptly become extremely brittle (possibly due to the presence of large numbers of maleimide chain ends not tied into the network). With a 1-hour postcure at 290 °C, system toughness is much more tolerant of excess BMI (Figure 2), even though toughness still peaks strongly at a stoichiometric ratio of BCB to maleimide groups.

Table 1

| Exp. | Phenothiazine[a] | BCB/BMI Molar ratio | Cure cycle[c] | Voids in casting | Dynamic mechanical: Tg (tan δ peak), °C | Rubbery plateau modulus, MPa | Compact tension fracture toughness, Kg, MPa.m$^{1/2}$ (ASTM E 399-83) | 93°C water absorption, %: 24 hr. | 1 week | 2 weeks | Gel content, %[f] |
|---|---|---|---|---|---|---|---|---|---|---|---|
| 1 | Yes | 0.333 | B | Few | d | | | | | | |
| 2 | Yes | 0.502 | A | Many | d | | | | | | 60.6 |
| 3 | Yes | 0.666 | B | | d | | | | | | |
| 4 | Yes | 0.753 | A | Many | d | | | | | | 63.6 |
| 5 | Yes | 0.816 | B | | d | | | | | | |
| 6 | Yes | 0.873 | B | None | 235 | 2 | 0.45±0.09 | | | | |
| 7 | Yes | 0.927 | B | Few | 245 | 1 | 4.77±0.89 | | | | |
| 8 | Yes | 0.964 | B | Very Few | 235 | 0.9 | 3.49±0.32 | | | | |
| 9 | Yes | 1.002 | A | Very Few | 227 | 2 | 3.40±0.14 | 1.49 | 2.25 | 1.47 | 87.3 |
| 10 | Yes | 1.01 | G | | 240[k] | | 4.74±0.04[k] | | | | |
| 11 | No | 1.01 | G | | 248[k] | | 2.83±0.002[k] | | | | |
| 12 | Yes | 1.077 | C | Many | 230 | 2 | 2.75±0.05 | 1.36 | 1.32 | 1.03 | |
| 13 | Yes | 1.078 | D | Many | 226 | 2 | 3.16±0.59 | | | | |
| 14 | Yes | 1.267 | B | None | 228 | 2 | 2.50±0.21 | 1.18 | 1.34 | 2.60 | 91.1 |
| 15 | Yes | 1.504 | B | Many | 227 | 2 | 2.17±0.13 | 1.07 | 1.19 | 1.26 | |
| 16 | Yes | 2.006 | C | Few | 231 | 6 | 2.29±0.72 | 0.91 | 0.99 | 1.10 | |
| 17 | Yes | 3.007 | B | None | 238 | 10 | 1.34±0.05 | | | | |
| 18 | Yes | 5.018 | B | None | 250 | 17 | 1.09±0.14 | 0.74 | 0.74 | 1.50 | |
| 19 | No | | E | None | >300 | g | 0.74[e] | 0.46[e] | 0.46 | 0.51 | |

Table 1 (cont'd)

| Exp. | Pheno thiazine[a] | BCB/BMI Molar ratio | Cure cycle[c] | Voids in casting | Dynamic mechanical: Tg (tan δ peak), °C | Dynamic mechanical: Rubbery plateau modulus, MPa | Compact tension fracture toughness, Kg, MPa.m$^{½}$ (ASTM E 399-83) | 93°C water absorption, %: 24 hr. | 93°C water absorption, %: 1 week | 93°C water absorption, %: 2 weeks | Gel content, %[f] |
|---|---|---|---|---|---|---|---|---|---|---|---|
| 20 | Yes | 0.333 | F | None | 310 | g | h | | | | |
| 21 | Yes | 0.429 | F | Few | 302 | g | 0.76±0.04 | | | | |
| 22 | No | 0.429 | F | None | 304 | g | 0.90±0.01 | | | | |
| 23 | Yes | 0.539 | F | Very few | 285 | 10 | 1.10±0.05 | | | | |
| 24 | Yes | 0.666 | F | Many | 265 | 6 | 1.95±0.29 | | | | |
| 25 | No | 0.666 | F | None | 274 | 9 | 1.70±0.06 | | | | |
| 26 | Yes | 0.745 | F | Few | 258 | 5 | 2.29±0.09 | | | | |
| 27 | No | 0.764 | F | None | 246 | 5 | 2.38±0.10 | | | | |
| 28 | Yes | 0.828 | F | Few | 248 | 4 | 3.01±0.15 | | | | |
| 29 | No | 0.873 | F | Few | 248 | 3 | 2.72±0.13 | | | | |
| 30 | Yes | 0.927 | F | Few | 237[i] | | 4.10±0.40 | | | | |
| 31 | Yes | 1.002 | F | Some | 239 | 2 | 3.71±0.14 | | | | |

[a] Phenothiazine when used, was incorporated at a level of 0.4 to 0.6 mole % (on total bismaleimides).

[c] Cure cycles:

A = 2 hr. 10 min. at 210°C, 20 min. at 220°C and 230°C, 25 min. at 240°C and 15 min. at 250°C.
B = 2 hr. 30 min. at 210°C, 15 min. at 220°C, 230°C, 240°C, and 250°C.
C = 2 hr. 15 min. at 210°C, 15 min. at 220°C, 230°C, 240°C, and 250°C.
D = 48 min. at 220°C, with temperature then reduced to 210°C for 1 hour, then 15 min. at 220°C, 230°C, 240°C and 250°C.
E = 2 hr. at 210°C, 15 min. at 220°C, 230°C, 240°C, and 250°C.
F = 3 hr. at 210°C, 15 min. at 230°C, 250°C, and 270°C, and 1 hr. at 290°C.
G = 3 hr. at 210°C, 15 min. at 220°, 230°, and 240°C, and 2 hr. at 250°C.

[d] Castings could not be tested because they were too brittle to be removed from the mould without shattering.

[e] Only one sample tested (other sample broke in test grips).

[f] The gel content was determined by soaking approximately 1 g of cured polymer in 100 mL of N-methylpyrrolidone (NMP) for 3 days at 80°C.
The NMP was then decanted and replaced with 50 mL of fresh NMP and the mixture was kept at 80°C for an additional day. The mixture was then poured into a tared fritted glass filter and the retained solids were rinsed with fresh NMP. The filter (containing the retained solids) was then dried to constant weight in a vacuum oven at 200°C.

[g] Tg was near upper temperature end of spectrum, hence no rubbery plateau module was reached.

[h] Test plaques broke during precracking procedure.

[i] Extrapolated (power failure occurred during temperature sweep shortly before Tg was reached, so this value was determined by extrapolating modulus curve).

[k] using mould with 3.18 mm spacer.

EXAMPLE II

Preparation of B1/BCB copolymer casting using three different BCB's

Following the procedure as described in Example 1 but employing a mould with a 3.18 mm spacer, castings were prepared based on mixtures comprising stoichiometric amounts of the B1 mixture (with and without phenothiazine) as prepared in Example 1 and respectively (4,4′-(1,3-phenylenedioxy)-bisbenzocyclobutene, 4,4′-(2,7-naphthylenedioxy)bisbenzocyclobutene, and 4,4′-(1,3-phenylene)-bisbenzocyclobutene). The castings were cured by the cure cycles shown in Table 2. (A higher postcure temperature was used for the system made from 4,4′-(1,3-phenylene)bisbenzocyclobutene because of the considerably higher final Tg of this system, 318° C as opposed to 240° and 270° C for the systems incorporating the phenylene diether and naphthylene diether bis-BCB resins.) The moulds were then allowed to cool to below 150° C and the cured resin castings were removed from the moulds. Physical properties of the castings were then determined as shown in Table 2.

One can see from Table 2 that as one proceeds in type of bisbenzocyclobutene resin used, from 4,4′-(1,3-phenylenedioxy)-bisbenzocyclobutene to 4,4′(2,7-naphthylenedioxy)bisbenzocyclobutene to 4,4′(1,3-phenylene)bisbenzocyclobutene (progressively increasing the ratio of "stiff" to "flexible" chain segments), the Tg steadily goes up (from 240° C to 310° C) with little or no loss of toughness.

Table 2

Properties of Castings Produced from BI/BCB Mixtures

| | | | | | |
|---|---|---|---|---|---|
| Resin[a]: | A | A | B | B | C |
| Phenothiazine[b] | No | Yes | No | Yes | Yes |
| Cure cycle[c] | A | A | A | A | B |
| Mechanical properties: | | | | | |
| Tg, dry, Rheometrics tan δ peak, °C | 242 | 235 | 273 | 270 | 310 |
| R.T. dry flex (ASTM D-790): | | | | | |
| Strength, MPa | 136 | 138 | 140 | 142 | 134 |
| Modulus, GPa | 3.93 | 3.71 | 3.44 | 3.30 | 3.74 |
| Elongation, % | 3.7 | 4.0 | 4.5 | 4.8 | 3.9 |
| 93°C wet flex (ASTM D-790): | | | | | |
| Strength, MPa | 109[c] | 90 | 109 | 101 | |
| Modulus, GPa | 3.49[c] | 3.38 | 3.37 | 3.16 | |
| Elongation, % | 5.8[c] | 9.8 | 7.8 | 4.0 | |
| Compact tension (ASTM E 399-83): | | | | | |
| Fracture toughness, Kg, $MPa \cdot m^{1/2}$ | 2.63±0.04 | 4.01±0.16 | 3.03±0.03 | 3.42±0.08 | 3.13±0.07 |

[a]Resin A = 4,4'-(1,3-phenylenedioxy)bisbenzocyclobutene
Resin B = 4,4'-(2,7-naphthylenedioxy)bisbenzocyclobutene
Resin C = 4,4'-(1,3-phenylene)bisbenzocyclobutene
All mixtures contained equimolar amounts of benzocyclobutene and maleimide groups.

[b]Phenothiazine when used, was incorporated at a level of 0.53 to 0.54 mole % (on total bismaleimides).

[c]Cure cycles:
A = 3 hours at 210°C followed by 15 minutes at 220°C, 230°C, and 240°C, and 2 hours at 250°C.
B = 2 hours at 210°C followed by 15 minutes at 230°C, 250°C, and 270°C, and 1 hour at 290°C.

## Comparative Experiment

### Preparation of Methylbis(4-benzocyclobutenyl)phosphine Oxide and BI/BCB Copolymer derived therefrom

This comparative example shows the lack of toughness obtained when a bisbenzocyclobutene component containing a substituent group which fairly strongly withdraws electrons from the benzocyclobutene ring system (in this case, the methylphosphine oxide group), is copolymerized with bismaleimides at a

near-stoichiometric ratio. All glassware used in this experiment was dried overnight in an oven at 120° C before use. Into a 240-mL, 4-neck round bottom glass flask were weighed 1.2287 grams (0.0505 mole) of magnesium turnings. The flask was then fitted with a thermometer, a condenser, a magnetic stirrer, and two addition funnels. To one addition funnel was added 10.12 grams (0.0553 mole) of 4-bromobenzocyclobutene. To the other was added 25 g of dry tetrahydrofuran. The system was purged with nitrogen. Small portions of the 4-bromobenzocyclobutene and tetrahydrofuran were dropped onto the magnesium and stirred until the Grignard reaction had started (which occurred in approximately 5 minutes). The reaction mixture was then cooled with an ice-water bath and the rest of the 4-bromobenzocyclobutene and tetrahydrofuran were added over approximately 50 minutes, with continued stirring and ice-bath cooling. During this period, the temperature of the reaction mixture was 45-55° C.

Then, under a stream of nitrogen, a solution of 3.11 grams (0.0234 moles) of methanephosphonic dichloride in 10 grams of tetrahydrofuran was poured into one of the addition funnels. It was then added dropwise to the Grigtiard reagent solution over approximately 30 minutes, as the reaction mixture was cooled to keep the temperature below approximately 45° C. The reaction was then allowed to proceed at room temperature for approximately 2 hours. Approximately 125 mL of water was then added to destroy excess Grignard reagent.

The mixture was then steam-distilled to remove volatiles and the residue was dissolved in dichloromethane. The dichloromethane layer was evaporated and the residue was recrystallized from 50 mL of 1,1,1-trichloroethane. Yield after recrystallization was 4.05 grams of small matted white crystals; m.p 176-182° C (rapid heating); purity by HPLC 99.8%.

The dried crystals were blended, at a 1.04:1 ratio of benzocyclobutene to maleimide groups, in a beaker with a phenothiazine-containing bismaleimide mixture similar to that prepared in Example 4 (total sample size was about 2.2 grams). The beaker was placed into an oven and the mixture was melted at 200° C, with the temperature later rising to 215° C (the latter temperature being needed in order to keep the mixture homogeneous). The mixture was then briefly degassed at 215° C in a vacuum oven. The mixture was then poured into a mould formed from two sheets of glass separated by a 1/16" (1.6 mm) polytetrafluoroethylene spacer and held together by clamps. It was placed in an oven and cured for 70 minutes at 220° C, 20 minutes at 230° C, 10 minutes at 240° C, 10 minutes at 250° C, 10 minutes at 260° C, 10 minutes at 270° C, 10 minutes at 280° C, and 15 minutes at 290° C. The mould was then allowed to cool below 150° C and the cured resin casting was removed from the mould. The casting was unlike the tough castings prepared in other examples from mixtures containing a near-stoichiometric ratio of benzocyclobutene to maleimide groups. The casting was extremely brittle and, indicative of the brittleness, a sliver could not be peeled from the edge of the casting with a knife.

EXAMPLE III

Homogeneous BI/BCB mixtures as employed in Example I exp. 10 and 11 were placed in small glass beakers which were partially immersed in an oil bath held at 220° C, and upstaged for 20 min. at 220° C to prevent the BI from crystallizing out on cooling.

The upstaged mixtures were then heated from room temperature to 260 °C at rate of 2° C/min. in a Rheometrics viscometer. For the phenothiazine-free mixture the viscosity was 4.2 Pa·s at 90° C and 0.1 Pa·s at 135 °C, and rose to 0.1 Pa·s again at 227 °C and to 2000 Pa·s at 245° C. With the phenothiazine-containing mixture the viscosity of the mixture was 0.36 Pa·s at 90 °C and less than 0.1 Pa·s at 135° C, and rose to 0.1 Pa·s again at 235° C and to 2000 Pa·s at 250° C. At each temperature, the viscosity was lower than for the phenothiazine-free system.

**Claims**

1. Heat-curable compositions comprising:
   a) at least one difunctional bisimide of an unsaturated dicarboxylic acid,
   b) 0.6-2.5 moles of a bisbenzocyclobutene per mole of bisimide, and
   c) optionally a free radical polymerization inhibitor for the bisimide.

2. Compositions as claimed in claim 1, wherein the bisbenzocyclobutene can be represented by one of formulas I, II and III

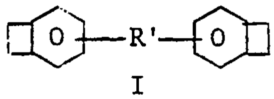

I

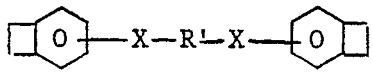

II

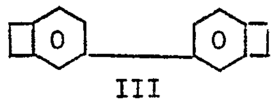

III

in which R′ is selected from phenylene, naphthylene, and

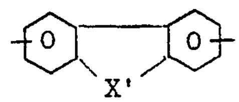

,

X is selected from oxygen, sulphur, nitrogen $-CH_2$ - and $-C(CH_3)_2$-, and X′ is selected from oxygen, sulphur, nitrogen and $-CH_2$-.

3. Compositions as claimed in claim 2, wherein R′ is 1,2-, 1,3-, 1,4-phenylene or naphthylene.

4. Compositions as claimed in claim 2 or 3, wherein X is oxygen.

5. Compositions as claimed in any one of claims 1-4, wherein the bisimide is a bismaleimide.

6. Compositions as claimed in any one of claims 1-5, wherein the bisbenzocyclobutene is present in an amount within the range of from 0.7 to 1.3 moles per mole of the bisimide.

7. Compositions as claimed in any one of claims 1-6, wherein the free radical inhibitor is present in an amount within the range of from 0.0002 to 0.02 moles per mole of the bisimide.

8. Compositions as claimed in any one of claims 1-7, wherein the free radical inhibitor is phenothiazine.

9. Compositions as claimed in any one of claims 5-8, wherein the bismaleimide is bis(4-maleimidophenyl)methane.

10. A process for the preparation of a polymeric composition which comprises:

a) the preparation of a blend based on a composition as claimed in any one of claim 1-9, and

b) heating said blend, optionally in contact with a fibrous substrate, to a temperature of at least 180 °C.

11. A process as claimed in claim 10, wherein the heating is conducted at a temperature in the range of from 200-350 °C for at least one hour.

12. A process as claimed in claim 10, wherein the composition includes a free radical inhibitor and the heating is conducted at a temperature in the range of from 210-350 °C for at least two hours.

13. A process as claimed in any one of claims 10-12, wherein the bisbenzocyclobutene can be represented by one of the formulas I, II and III, and the blend is heated to a temperature of at least ($Tg_u$-15 °C) where $Tg_u$ is the ultimate glass transition temperature of the bisbenzocyclobutene/bisimide copolymer, for a time sufficient for essentially complete reaction of the bisimide and the bisbenzocyclobutene.

14. Polymeric compositions prepared according to a process as claimed in any one of the claims 10-13.

15. Shaped articles at least partially comprising a polymeric composition as claimed in claim 14.

FIG.1

Effect of posture temperature and mole fraction BCB on Tg of BCB/BMI copolymers

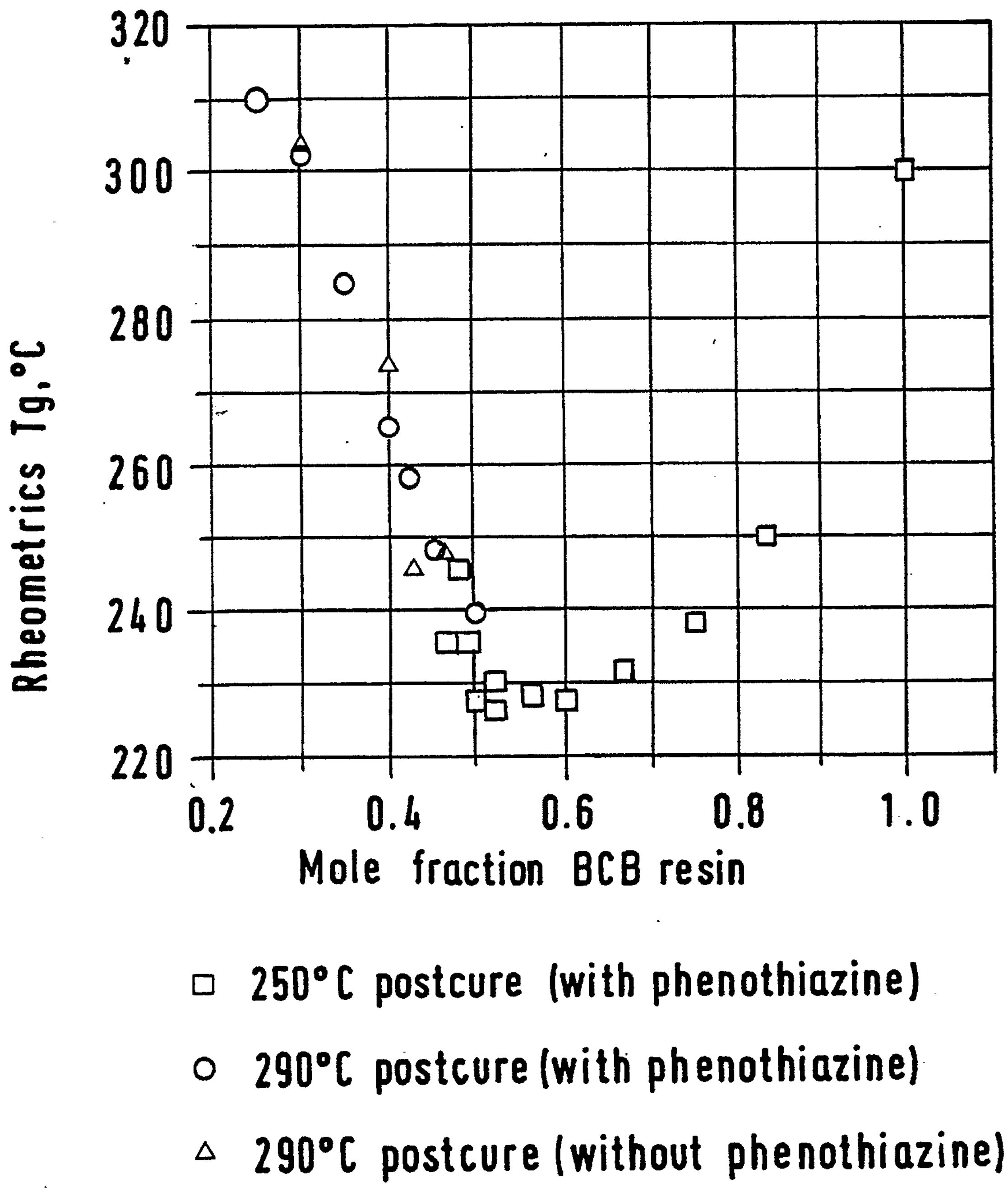

FIG. 2

Effect of posture temperature and mole fraction of BCB on toughness of BCB/ BMI copolymers.

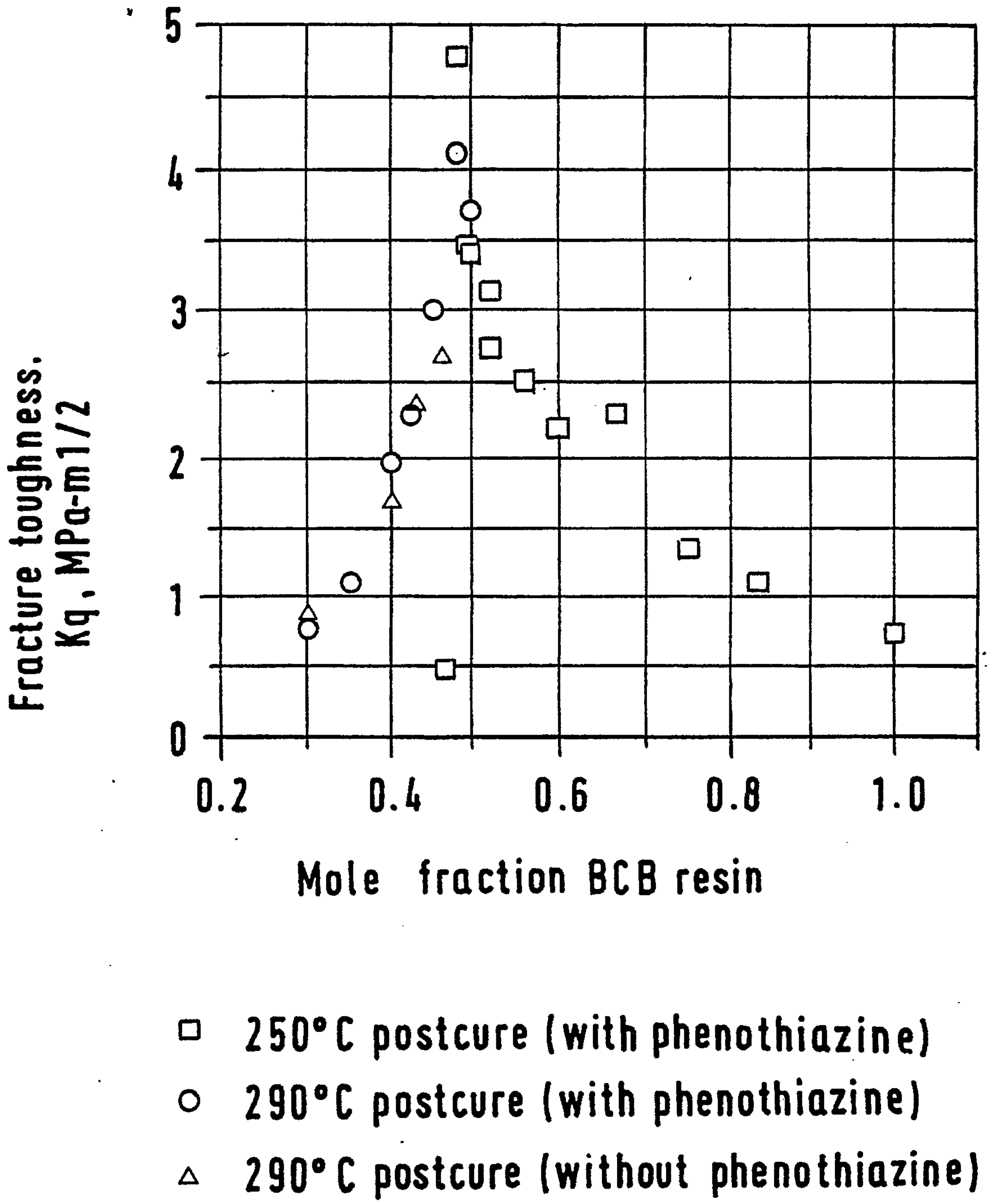

European Patent Office

# EUROPEAN SEARCH REPORT

Application Number

EP 90 20 1362

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | US-A-4 730 030 (PATTERSON et al.)<br>----- | | C 08 G 61/00<br>C 08 G 73/12 |
| | | | **TECHNICAL FIELDS SEARCHED (Int. Cl.5)** |
| | | | C 08 G |

The present search report has been drawn up for all claims

| Place of search | Date of completion of the search | Examiner |
|---|---|---|
| THE HAGUE | 10-09-1990 | LEROY ALAIN |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)